# EUROPEAN PATENT APPLICATION

(11) **EP 4 443 519 A1**
(43) Date of publication of application: **09.10.2024**
(21) Application number: 21969287.8
(22) Date of filing: 27.12.2021
(51) Int. Cl.: H01L 29/78, H01L 21/8238

(54) **SEMICONDUCTOR DEVICE AND MANUFACTURING METHOD THEREFOR, AND ELECTRONIC DEVICE**

(71) Applicant: Huawei Technologies Co., Ltd., Shenzhen, Guangdong 518129 (CN)
(72) Inventor: ZHANG, Kehao, Shenzhen, Guangdong 518129 (CN); LIU, Xi, Shenzhen, Guangdong 518129 (CN); YE, John, Shenzhen, Guangdong 518129 (CN); LIN, Jun, Shenzhen, Guangdong 518129 (CN)
(74) Representative: Pfenning, Meinig & Partner mbB
(86) International application number: PCT/CN2021/141751
(87) International publication number: WO 2023/122901

(57) **Abstract**

This application provides a semiconductor device, a semiconductor device manufacturing method, and an electronic device, and relates to the field of semiconductor technologies, to reduce an equivalent oxide thickness (EOT). The semiconductor device includes a transistor using a high-dielectric-constant metal gate (HKMG) structure. The high-dielectric-constant metal gate structure includes a dielectric layer, a high-dielectric-constant oxide layer, and a composite layer. The high-dielectric-constant oxide layer covers the dielectric layer. The composite layer covers the high-dielectric-constant oxide layer. The composite layer includes a first metal oxide layer, a first metal layer, and a second metal oxide layer that are sequentially disposed in a stacked manner. The first metal oxide layer and the second metal oxide layer each include a conductive metal oxide, and metal elements included in the first metal oxide layer, the first metal layer, and the second metal oxide layer are the same.

## Description

### TECHNICAL FIELD

This application relates to the field of semiconductor technologies, and in particular, to a semiconductor device, a semiconductor device manufacturing method, and an electronic device.

### BACKGROUND

As a new complementary metal oxide semiconductor (complementary metal oxide semiconductor, CMOS) transistor, a fin field effect transistor (fin field effect transistor, FinFET) is one of main devices in an integrated circuit (integrated circuit, IC). In an advanced process node below 22 nm, the FinFET is usually equipped with a high-dielectric-constant metal gate (high-K metal gate, HKMG) structure.

Compared with a conventional polycrystalline silicon/silicon dioxide gate dielectric layer structure, an HKMG technology uses a combination of a high-dielectric-constant gate oxide layer and a metal gate. This can not only greatly reduce a leakage amount of a gate, but also effectively increase a gate capacitance by using a small equivalent oxide thickness (equivalent oxide thickness, EOT), thereby increasing a drive current. However, as a size of the integrated circuit is continuously reduced, the equivalent oxide thickness (EOT) needs to be further reduced. However, under a current process node, the equivalent oxide thickness (EOT) has been reduced to a value close to a physical theoretical limit, and it is difficult to further reduce the EOT.

### SUMMARY

Embodiments of this application provide a semiconductor device, a semiconductor device manufacturing method, and an electronic device, to reduce an equivalent oxide thickness (EOT).

This application provides a semiconductor device, including a transistor using a high-dielectric-constant metal gate (HKMG) structure. The high-dielectric-constant metal gate structure includes a dielectric layer, a high-dielectric-constant oxide layer, and a composite layer. The high-dielectric-constant oxide layer covers the dielectric layer. The composite layer covers the high-dielectric-constant oxide layer. The composite layer includes a first metal oxide layer, a first metal layer, and a second metal oxide layer that are sequentially disposed in a stacked manner. The first metal oxide layer and the second metal oxide layer each include a conductive metal oxide, and metal elements included in the first metal oxide layer, the first metal layer, and the second metal oxide layer are the same. The first metal oxide layer is closer to the high-dielectric-constant oxide layer than the second metal oxide layer.

In the semiconductor device provided in embodiments of this application, for the high-dielectric-constant metal gate structure, the composite layer is disposed on a surface of the high-dielectric-constant oxide layer. The composite layer uses a "sandwich"-shaped composite film layer made of first metal oxide layer/first metal layer/second metal oxide layer having the same metal element. Compared with a related technology in which a capping layer (TiN layer) and an etch stop layer (TaN layer) are disposed on a surface of a high-dielectric-constant oxide layer, in this application, the capping layer (TiN layer) and the etch stop layer (TaN layer) are replaced by the composite layer. A metal material used in the first metal layer has a stronger oxygen capture capability than the capping layer (TiN layer). Therefore, oxygen atoms can be captured in the dielectric layer, thereby reducing the equivalent oxide thickness (EOT) of the device and enhancing a gate control capability of the transistor. As an interface layer between the first metal layer and the high-dielectric-constant oxide layer, the first metal oxide layer can well prevent oxygen atoms in the high-dielectric-constant oxide layer from spreading outward, and suppress an oxygen defect generated due to a thermal effect in the high-dielectric-constant oxide layer. The second metal oxide layer is used as a water-oxygen barrier layer to prevent water vapor, oxygen, and the like from entering the first metal layer, and avoid damage caused by the water vapor, the oxygen, and the like to the first metal layer. In other words, the second metal oxide layer protects the first metal layer. In addition, in this application, the composite layer is made of a metal material and a metal oxide material, and no annealing process needs to be performed, so that a problem of an increase of the equivalent oxide thickness due to annealing is avoided.

In addition, the composite layer is made of a metal material and a metal oxide material that have the same metal element, so that an in-situ atomic layer deposition composite layer (including the first metal oxide layer, the first metal layer, and the second metal oxide layer) may be used during manufacturing. In this case, the composite layer is equivalent to a single film layer. Compared with two film layers (to be specific, a capping layer and an etch stop layer) used in a related technology, the composite layer is thinner, so that more space can be provided for subsequent filling of a metal gate layer. This can reduce a gate resistance.

In some possible implementations, the first metal layer may include at least one of Ru and Ir.

In some possible implementations, the first metal oxide layer may include at least one of RuO₂ and IrO₂. The second metal oxide layer may include at least one of RuO₂ and IrO₂.

In some possible implementations, the composite layer uses a composite film layer made of RuO₂/Ru/RuO₂.

In some possible implementations, a thickness of the composite layer is less than or equal to 20 Å. Compared with disposition of the foregoing capping layer and etch stop layer, to ensure continuity of the two film layers, a total thickness of the two film layers usually needs to be set to be greater than 30 Å. However, in this application, the composite layer made of the metal material and the metal oxide material may use in-situ atomic layer deposition, and is equivalent to a single film layer, and a thickness of the composite layer may be less than 20 Å.

In some possible implementations, the dielectric layer may include SiO₂. The high-dielectric-constant oxide layer may include at least one of HfO₂ and ZrO₂.

In some possible implementations, the high-dielectric-constant metal gate further includes a work function layer, a glue layer, and a metal gate layer that are sequentially disposed on a surface of the composite layer in a stacked manner.

In some possible implementations, the metal gate layer may be made of one or more of Al, W, Ru, Co, and Mo.

In some possible implementations, the glue layer may be made of one or more of TiN, TiON, TiSiN, and TaN.

In some possible implementations, the work function layer may include an N-type work function layer and a P-type work function layer.

In some possible implementations, the P-type work function layer may be made of one or more of TiAlN, TiSiN, TiN, and MoN. The N-type work function layer may be made of one or more of TiN, TiAl, TiAlC, TiON, TiSiN and TaN.

In some possible implementations, the transistor is a fin field effect transistor.

In some possible implementations, the transistor is a gate all around field effect transistor.

An embodiment of this application further provides a semiconductor device manufacturing method, including: sequentially forming a dielectric layer and a high-dielectric-constant oxide layer on a substrate; and sequentially forming a first metal oxide layer, a first metal layer, and a second metal oxide layer on a surface of the high-dielectric-constant oxide layer. The first metal oxide layer and the second metal oxide layer each include a conductive metal oxide, and metal elements included in the first metal oxide layer, the first metal layer, and the second metal oxide layer are the same.

In some possible implementations, the sequentially forming a first metal oxide layer, a first metal layer, and a second metal oxide layer on a surface of the high-dielectric-constant oxide layer may include: sequentially depositing the first metal oxide layer, the first metal layer, and the second metal oxide layer on the surface of the high-dielectric-constant oxide layer through in-situ atomic layer deposition.

The first metal oxide layer, the first metal layer, and the second metal oxide layer (that is, a composite layer) that are formed by using an in-situ atomic layer are equivalent to a single film layer. Compared with two film layers (to be specific, a capping layer and an etch stop layer) used in a related technology, the composite layer is thinner, so that more space can be provided for subsequent filling of a metal gate layer. This can reduce a gate resistance. For example, compared with a thickness that is of the capping layer and the etch stop layer and that is greater than 30 Å, a thickness of the composite layer formed by using the in-situ atomic layer may be less than 20 Å.

An embodiment of this application further provides an electronic device, including a printed circuit board and the semiconductor device provided in any one of the foregoing possible implementations. The semiconductor device is electrically connected to the printed circuit board.

### BRIEF DESCRIPTION OF DRAWINGS

FIG. 1 is a diagram of a partial structure of a FinFET in a semiconductor device according to a related technology of this application;
FIG. 2 is a diagram of layers of an HKMG in the FinFET in FIG. 1;
FIG. 3 is a diagram of layers of an HKMG according to this application;
FIG. 4 is a diagram of comparison between an HKMG according to this application and an HKMG in a related technology;
FIG. 5 is a diagram of layers of an HKMG according to this application;
FIG. 6 is a diagram of a manufacturing process of a P-type work function layer in an HKMG according to this application;
FIG. 7 is a flowchart of a semiconductor device manufacturing method according to this application;
FIG. 8 is a diagram of a semiconductor device manufacturing process according to this application;
FIG. 9 is a diagram of a semiconductor device manufacturing process according to this application;
FIG. 10 is a flowchart of manufacturing some film layers in a semiconductor device according to this application; and
FIG. 11 is a diagram of a partial structure of a GAA in a semiconductor device according to an embodiment of this application.

### DESCRIPTION OF EMBODIMENTS

To make the objectives, technical solutions, and advantages of this application clearer, the following clearly describes the technical solutions in this application with reference to the accompanying drawings in this application. It is clear that the described embodiments are merely some rather than all of embodiments of this application. All other embodiments obtained by a person of ordinary skill in the art based on embodiments of this application without creative efforts shall fall within the protection scope of this application.

In the specification, embodiments, claims, and accompanying drawings of this application, the terms "first", "second", and the like are merely intended for distinguishing and description, and shall not be understood as indicating or implying relative importance, or indicating or implying a sequence. The terms such as "connection", "connected", and the like are used for indicating interworking or mutual interaction between different components, and may include a direct connection or an indirect connection via another component. In addition, the terms "include", "have", and any variant thereof are intended to cover non-exclusive inclusion. For example, a process, method, system, product, or device that includes a series of steps or units is not necessarily limited to those steps or units expressly listed, but may include other steps or units not expressly listed or inherent to such a process, method, system, product, or device. "On", "below", "left", "right", and the like are used only relative to the orientation of the components in the accompanying drawings. These directional terms are relative concepts, are used for relative descriptions and clarifications, and may change accordingly as positions at which the components in the accompanying drawings are placed change.

It should be understood that in this application, "at least one (item)" means one or more and "a plurality of" means two or more. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" generally indicates an "or" relationship between the associated objects. The expression "at least one of the following items (pieces)" or a similar expression means any combination of these items, including a single item (piece) or any combination of a plurality of items (pieces). For example, at least one of a, b, or c may indicate a, b, c, a and b, a and c, b and c, or a, b, and c, where a, b, and c may be singular or plural.

An embodiment of this application provides an electronic device. The electronic device includes a printed circuit board (printed circuit board, PCB) and a semiconductor device electrically connected to the printed circuit board. A transistor is disposed in the semiconductor device. A disposition form of the semiconductor device is not limited in this application. For example, the semiconductor device may be a device such as a memory chip or a logic chip.

A disposition form of the electronic device is not limited in this application. For example, the electronic device may be an electronic product such as a mobile phone, a tablet computer, a notebook computer, a vehicle-mounted computer, a smartwatch, or a smart band.

In the electronic device provided in this embodiment of this application, a non-planar field effect transistor such as a fin field effect transistor (fin field effect transistor, FinFET) or a gate all around field effect transistor (gate all around field effect transistor, GAA) is used as the transistor inside the semiconductor device. The non-planar field effect transistor uses a new high-dielectric-constant metal gate structure (HKMG for short below). A "sandwich"-shaped composite film layer made of metal oxide/metal/metal oxide is disposed on a surface of a high-dielectric-constant oxide layer (that is, a high-K layer), to reduce an equivalent oxide thickness (EOT) of the HKMG, thereby increasing a gate capacitance and enhancing a gate control capability of the transistor.

An example in which the FinFET is used in the semiconductor device is used. The following specifically describes disposition of the HKMG provided in this embodiment of this application with reference to disposition of an HKMG in a semiconductor device in a related technology.

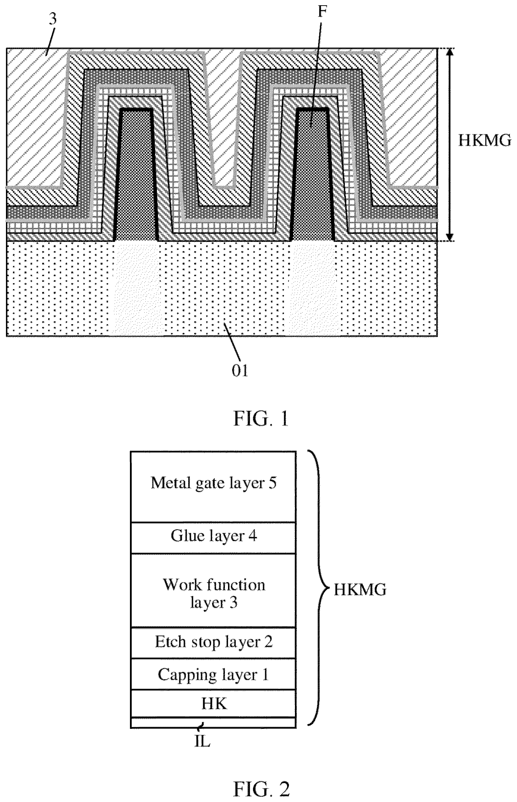

FIG. 1 is a diagram of a partial structure of a FinFET in a semiconductor device in a related technology. FIG. 2 is a diagram of layers of an HKMG in the FinFET in FIG. 1. As shown in FIG. 1 and FIG. 2, the FinFET includes a substrate 01 and a fin structure F (fin) disposed on the substrate 01. The HKMG is disposed on a surface of the fin structure F. As shown in FIG. 2, the HKMG includes a dielectric layer IL (inter layer, which may also be referred to as an intermediate oxide layer or an interlayer dielectric layer), a high-dielectric-constant oxide layer HK, a capping layer 1 (capping layer), an etch stop layer 2 (etch stop layer, ESL), a work function layer 3, a glue layer 4, and a metal gate layer 5 that are sequentially disposed in a stacked manner. The dielectric layer IL and the high-dielectric-constant oxide layer HK are used as equivalent oxide layers in the HKMG, and directly affect a gate control capability of the FinFET. The capping layer 1 is disposed to protect a high-dielectric-constant oxide (that is, a high-K material) in the high-dielectric-constant oxide layer HK, and prevent oxygen atoms in the high-K material from spreading outwards. The etch stop layer 2 is disposed to ensure that manufacturing of a subsequent film layer (for example, the work function layer) does not affect the capping layer 1. Generally, the capping layer 1 is made of TiN, and the etch stop layer 2 is made of TaN. The work function layer 3 is configured to adjust a work function of the HKMG. The glue layer 4 has a gluing effect on the metal gate layer 40, to ensure reliability of the metal gate layer 40.

Certainly, for the FinFET, in addition to the foregoing HKMG, other components such as a source and a drain are further disposed. Details are not described in this application. This application mainly describes disposition of the HKMG.

The foregoing semiconductor device has the following problems.

First, because the capping layer 1 is made of metal nitride, in a subsequent annealing process, SiO₂ used in the dielectric layer IL regrows (in other words, a thickness of the dielectric layer IL is increased). Consequently, an equivalent oxide thickness (EOT) is increased, a gate capacitance is reduced, and the gate control capability of the FinFET is reduced.

Second, to ensure that both the capping layer 1 and the etch stop layer 2 are continuous thin films, a total thickness of the capping layer 1 and the etch stop layer 2 is greater than 30 Å. In other words, the equivalent oxide thickness (EOT) is large. In this case, as a gate length of the FinFET is continuously reduced, especially in a short gate length process, because the total thickness of the capping layer 1 and the etch stop layer 2 is large, a void is caused because space for filling the metal gate layer 5 in a trench is insufficient subsequently. When a specific threshold voltage (for example, a P-type ultra-low threshold voltage) is set, because the metal gate layer 5 cannot be fully filled, a gate resistance is increased, and stability of the device is affected.

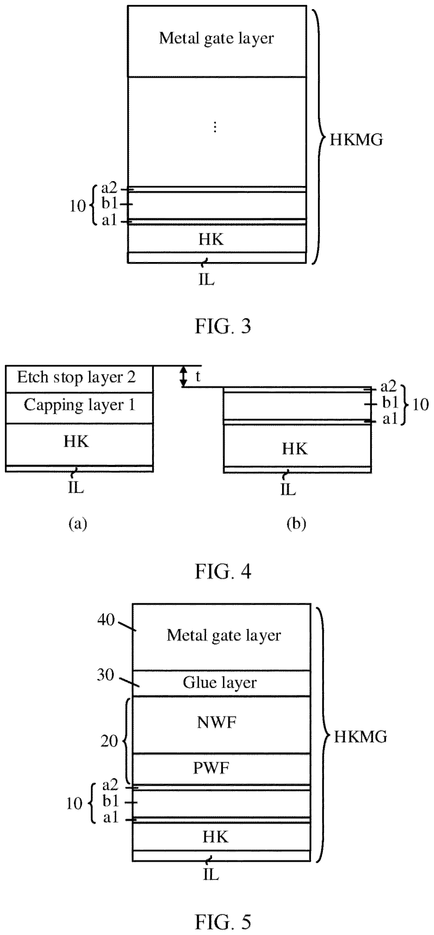

In comparison, as shown in FIG. 3, in a semiconductor device provided in an embodiment of this application, an HKMG of a FinFET also uses a dielectric layer IL and a high-dielectric-constant oxide layer HK as equivalent oxide layers. In addition, a composite layer 10 is disposed on a surface of the high-dielectric-constant oxide layer HK, to replace the foregoing capping layer 1 and etch stop layer 2, so that an equivalent oxide thickness (EOT) can be reduced. For example, the dielectric layer IL may be made of SiO₂. The high-dielectric-constant oxide layer HK may be made of a material whose high dielectric constant is greater than 20, for example, HfO₂ or ZrO₂. However, this application is not limited thereto.

Specifically, refer to FIG. 3. The composite layer 10 may include a first metal oxide layer a1, a first metal layer b1, and a second metal oxide layer a2 that are sequentially disposed in a stacked manner. The first metal oxide layer a1 is closer to the high-dielectric-constant oxide layer HK than the second metal oxide layer a2. In other words, the first metal oxide layer a1, the first metal layer b1, and the second metal oxide layer a2 are sequentially disposed on the surface of the high-dielectric-constant oxide layer HK in a stacked manner. The first metal oxide layer a1 and the second metal oxide layer a2 each are made of a conductive metal oxide, and metal elements included in the first metal oxide layer a1, the first metal layer b1, and the second metal oxide layer a2 are the same. In other words, materials of the first metal oxide layer a1 and the second metal oxide layer a2 are oxides of a metal material of the first metal layer b1, and the metal oxide is a conductive material.

In this embodiment of this application, the metal material used in the first metal layer b has a stronger oxygen capture capability than metal nitride (which is the foregoing capping layer 1). Therefore, oxygen atoms can be captured in the dielectric layer IL, so that a thickness of the dielectric layer IL is reduced, thereby reducing the equivalent oxide thickness (EOT) of the device and enhancing a gate control capability of a transistor. As an interface layer between the first metal layer b1 and the high-dielectric-constant oxide layer HK, the first metal oxide layer a1 can well prevent oxygen atoms in the high-dielectric-constant oxide layer HK from spreading outwards, and suppress an oxygen defect generated due to a thermal effect in the high-dielectric-constant oxide layer HK. The second metal oxide layer a2 is used as a water-oxygen barrier layer to prevent water vapor, oxygen, and the like from entering the first metal layer b1, and avoid damage cause by the water vapor, the oxygen, and the like to the first metal layer b1. In other words, the second metal oxide layer a2 protects the first metal layer b1.

For example, in some possible implementations, the first metal layer b1 may be made of at least one of metal materials such as Ru and Ir.

For example, in some possible implementations, the first metal oxide layer a1 may be made of at least one of conductive metal oxide materials such as RuO₂ and IrO₂. The second metal oxide layer a2 may use at least one of conductive metal oxide materials such as RuO₂ and IrO₂.

An example in which the first metal layer b1 is made of Ru is used. In some possible implementations, the semiconductor device uses a silicon substrate. After the transistor is manufactured, hydrogen (H₂) needs to be used as a protective gas to perform an annealing (annealing) process. Ru used in the first metal layer b1 has a catalytic effect, and can enable H₂ to be decomposed into an H free radical, where the H free radical has a better reaction activity than H₂. Therefore, in the annealing process, it is more conducive to terminating a dangling bond (dangling bond) of Si (silicon substrate), thereby reducing a trap caused by an interface state defect and improving reliability of the device.

Actual materials of the first metal oxide layer a1, the first metal layer b 1, and the second metal oxide layer a2 in the composite layer 10 may be selected based on a requirement. For example, in some embodiments, the first metal layer b1 may be made of Ru, and both the first metal oxide layer a1 and the second metal oxide layer a2 may be made of RuO₂. In other words, the composite layer 10 uses a composite film layer made of RuO₂/Ru/RuO₂. Certainly, in some other embodiments, the first metal layer b1 may be made of Ir, and both the first metal oxide layer a1 and the second metal oxide layer a2 may be made of IrO₂. In other words, the composite layer 10 uses a composite film layer made of IrO₂/Ir/IrO₂.

It should be understood herein that, the composite layer 10 is made of a metal material and a conductive metal oxide material, and no annealing process needs to be performed in a manufacturing process of the composite layer 10. In this way, regrowth of SiO₂ in the dielectric layer IL due to annealing is avoided, in other words, a problem of an increase of the equivalent oxide thickness (EOT) due to annealing is avoided.

In addition, because the metal elements of the first metal oxide layer a1, the first metal layer b 1, and the second metal oxide layer a2 in the composite layer 10 are the same, the first metal oxide layer a1, the first metal layer b 1, and the second metal oxide layer a2 may be formed through in-situ atomic layer deposition (in-situ atomic layer deposition, in-situ ALD) during manufacturing. For specific manufacturing, refer to the following related descriptions. In this case, the composite layer 10 is equivalent to a thin film, so that a thickness of the composite layer 10 can be less than 20 Å (in other words, less than or equal to 20 Å).

Based on this, as shown in FIG. 4, compared with disposition of the foregoing capping layer 1 (TiN) and etch stop layer 2 (TaN), to ensure continuity of the two film layers (1 and 2), a total thickness of the two film layers (1 and 2) usually needs to be set to be greater than 30 Å. However, in this application, the composite layer 10 made of the metal material and the metal oxide material may use in-situ atomic layer deposition, and is equivalent to a single film layer. The thickness (which is less than 20 Å) of the composite layer 10 has a specific thickness difference t compared with the thickness (which is greater than 30 Å) of the capping layer 1 and the etch stop layer 2. The single film layer (that is, the composite layer 10) is used to replace the two film layers (1 and 2), so that more space can be provided for subsequent filling of a metal gate layer. This can reduce a gate resistance.

For example, in some possible implementations, in the composite layer 10, a thickness of the first metal oxide layer a1 may be less than or equal to 10 Å, a thickness of the first metal layer b 1 may be less than or equal to 10 Å, and a thickness of the second metal oxide layer a2 may be less than or equal to 10 Å. For example, in some embodiments, the thickness of the first metal oxide layer a1 may be set to 5 Å, the thickness of the first metal layer b 1 may be set to 10 Å, and the thickness of the second metal oxide layer a2 may be set to 5 Å.

In addition, for the entire HKMG, there is usually another film layer on a surface of the composite layer 10. For example, as shown in FIG. 5, in some possible implementations, for the HKMG, a work function layer 20, a glue layer 30, and a metal gate layer 40 are sequentially disposed on the surface of the composite layer 10 in a stacked manner.

The metal gate layer 40 may be filed by using a low-resistance metal material. For example, the metal gate layer 40 may be made of one or more of materials such as Al, W, Ru, Co, and Mo, but this is not limited thereto.

Disposition of the glue layer 30 (glue layer) can have a gluing effect on the metal gate layer 40, to ensure reliability of the metal gate layer 40. For example, the glue layer 30 may be made of one or more of materials such as TiN, TiON, TiSiN, and TaN, but this is not limited thereto.

The foregoing work function layer 20 is disposed to adjust a work function of the HKMG, to adjust a work function and a threshold voltage of the transistor. As shown in FIG. 5, in some embodiments, the work function layer 20 may include a P-type work function layer PWF and an N-type work function layer NWF that are sequentially disposed on the surface of the composite layer 10 in a stacked manner, to adjust work functions and threshold voltages of an N-type transistor (that is, an NMOS) and a P-type transistor (that is, a PMOS) in the semiconductor device. The N-type work function layer NWF mainly adjusts the work function and the threshold voltage of the NMOS. The P-type work function layer PWF mainly adjusts the work function and the threshold voltage of the PMOS. Certainly, in some embodiments, both the P-type work function layer PWF and the N-type work function layer NWF may be generally disposed to adjust the work functions and the threshold voltages.

For example, the P-type work function layer PWF may be made of one or more of materials such as TiAlN, TiSiN, TiN, and MoN, but this is not limited thereto. The N-type work function layer NWF may be made of one or more of materials such as TiN, TiAl, TiAlC, TiON, TiSiN, and TaN, but this is not limited thereto.

In some possible implementations, in the HKMG, multi-threshold voltage regulation is implemented by using the work function layer 20, and this is implemented mainly by setting different thicknesses of the P-type work function layer PWF in different areas.

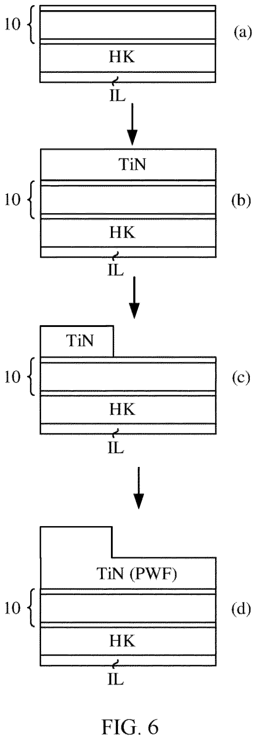

As shown in FIG. 6, an example in which the P-type work function layer PWF is made of TiN is used. When the P-type work function layer PWF is manufactured on the surface of the composite layer 10, a TiN thin film with a specific thickness may be first deposited, and the TiN thin film in some areas is removed through wet etching. Then, a TiN thin film with a specific thickness continues to be deposited. Processes (b), (c), and (d) in FIG. 6 are repeated for a plurality of times based on an actual requirement, to obtain the P-type work function layer PWF.

It may be understood that there is a high etching ratio (where the etching ratio is greater than 500) between the material (metal material and metal oxide material) used in the composite layer 10 and the subsequently formed work function layer 20 (for example, the PWF), so that an etch stop layer does not need to be disposed between the composite layer 10 and the work function layer 20.

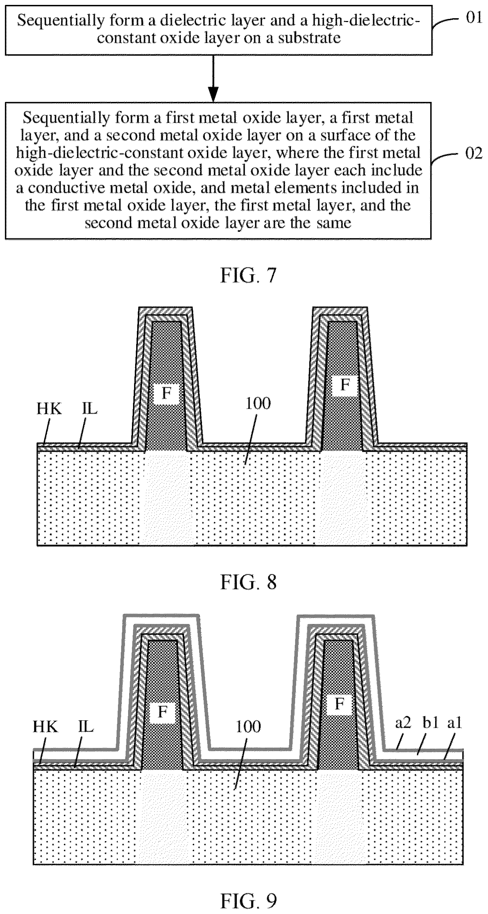

An embodiment of this application further provides a semiconductor device manufacturing method according to any one of the foregoing possible implementations. As shown in FIG. 7, the manufacturing method may include the following steps.

Step 01: Sequentially form a dielectric layer IL and a high-dielectric-constant oxide layer HK on a substrate 100, as shown in FIG. 8.

For example, as shown in FIG. 8, the substrate 100 may include a silicon substrate and other components that are formed on a surface of the silicon substrate, for example, a fin structure F of a transistor and a channel doping area below the fin structure F.

For example, in some possible implementations, a SiO₂ layer (IL) and a HfO₂ layer (HK) may be sequentially deposited on a surface of the substrate 100 by performing step 01.

Step 02: Sequentially form a first metal oxide layer a1, a first metal layer b1, and a second metal oxide layer a2 on a surface of the high-dielectric-constant oxide layer HK, as shown in FIG. 9. The first metal oxide layer and the second metal oxide layer each include a conductive metal oxide, and metal elements included in the first metal oxide layer, the first metal layer, and the second metal oxide layer are the same.

In some possible implementations, step 02 may include: sequentially depositing the first metal oxide layer a1, the first metal layer b1, and the second metal oxide layer a2 on the surface of the high-dielectric-constant oxide layer HK through in-situ atomic layer deposition (in-situ atomic layer deposition, in-situ ALD).

For example, in some possible implementations, as shown in FIG. 9, a RuO₂ film layer (a1), a Ru film layer (b1), and a RuO₂ film layer (a2) may be sequentially deposited on the surface of the high-dielectric-constant oxide layer HK (for example, the HfO₂ layer) in the manner of in-situ atomic layer deposition by performing step 02.

The following briefly describes how to form the Ru film layer and the RuO₂ film layer in the manner of in-situ atomic layer deposition.

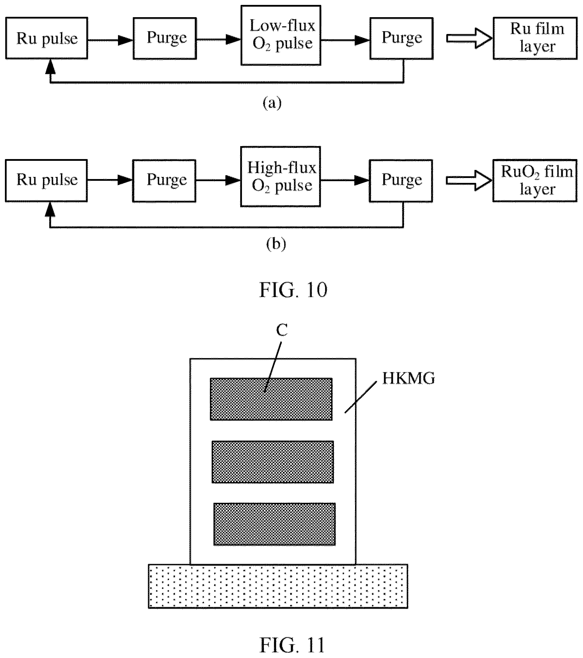

As shown in (a) and (b) in FIG. 10, a metal precursor (Ru pulse) and a reactive gas (such as an oxygen pulse or an ozone pulse) may cyclically pass through a reaction chamber. Purging (purge) needs to be performed between precursor pulses. A composition of a generated film layer is controlled by controlling a flow rate and flux time of the reactive gas. Low-flux oxygen (O₂) is used to form the Ru film layer, and high-flux oxygen (O₂) is used to form the RuO₂ film layer.

According to a semiconductor device formed by using the manufacturing method in this embodiment of this application, the first metal oxide layer a1, the first metal layer b1, and the second metal oxide layer a2 are sequentially deposited on the surface of the high-dielectric-constant oxide layer HK. A metal material used in the first metal layer b1 has a strong oxygen capture capability, so that oxygen atoms can be captured in the dielectric layer IL, thereby reducing an EOT of the device and enhancing a gate control capability of the transistor. As an interface layer between the first metal layer b1 and the high-dielectric-constant oxide layer HK, the first metal oxide layer a1 can well prevent oxygen atoms in the high-dielectric-constant oxide layer HK from spreading outwards, and suppress an oxygen defect generated due to a thermal effect in the high-dielectric-constant oxide layer HK. As a water-oxygen barrier layer, the second metal oxide layer a2 protects the first metal layer b1, to prevent the first metal layer b1 from being damaged, for example, corroded.

In addition, in this application, a composite layer is made of a metal material and a metal oxide material, and no annealing process needs to be performed, so that a problem of an increase of the equivalent oxide thickness due to annealing is avoided.

For the foregoing composite layer (including the first metal oxide layer, the first metal layer, and the second metal oxide layer) formed by using an in-situ atomic layer, the composite layer is equivalent to a single film layer. Compared with two film layers (to be specific, a capping layer and an etch stop layer) used in a related technology, the composite layer is thinner, so that more space can be provided for subsequent filling of a metal gate layer. This can reduce a gate resistance. For example, compared with a thickness that is of a capping layer 1 and an etch stop layer 2 and that is greater than 30 Å, a thickness of the composite layer formed by using the in-situ atomic layer may be less than or equal to 20 Å.

Certainly, for the foregoing semiconductor device manufacturing method, with reference to FIG. 1 and as shown in FIG. 4, after step 02, other film layers, for example, the work function layer 20, the glue layer 30, and the metal gate layer 40, usually further need to be manufactured. This is not limited in this application. Subsequent manufacturing may be performed based on an actual requirement.

For other content of the foregoing embodiment of the semiconductor device manufacturing method, correspondingly refer to related content of the foregoing embodiment of the semiconductor device. For the foregoing embodiment of the semiconductor device, refer to the foregoing embodiment of the semiconductor device manufacturing method, or corresponding adjustment may be made with reference to another related manufacturing method. Details are not described herein again.

The foregoing embodiments are described by using a fin field effect transistor (FinFET) using an HKMG as an example. For a gate all around field effect transistor (GAA) using an HKMG, an inter-layer structure of the HKMG may be similar to an inter-layer structure of the HKMG in the foregoing FinFET. For details, refer to related content in the foregoing embodiments. Details are not described herein again.

As shown in FIG. 11, different from that the HKMG covers a surface of a fin structure F (which is equivalent to a channel) in the FinFET, in the GAA, the HKMG is disposed around a plurality of channels C. The channel C of the GAA may be a nanowire (nanowire), or may be a nanosheet (nanosheet). FIG. 11 is merely described by using an example in which the channel C uses the nanochip. Certainly, other components such as a source and a drain are further disposed in the GAA. For details, refer to related content. Details are not described herein again.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A semiconductor device, comprising a transistor using a high-dielectric-constant metal gate structure, wherein the high-dielectric-constant metal gate structure comprises a dielectric layer, a high-dielectric-constant oxide layer, and a composite layer;
the high-dielectric-constant oxide layer covers the dielectric layer; and
the composite layer covers the high-dielectric-constant oxide layer, the composite layer comprises a first metal oxide layer, a first metal layer, and a second metal oxide layer that are sequentially disposed in a stacked manner, the first metal oxide layer and the second metal oxide layer each comprise a conductive metal oxide, and metal elements comprised in the first metal oxide layer, the first metal layer, and the second metal oxide layer are the same.

2. The semiconductor device according to claim 1, wherein
the first metal layer comprises at least one of Ru or Ir.

3. The semiconductor device according to claim 1 or 2, wherein
the first metal oxide layer comprises at least one of RuO₂ or IrO₂; and
the second metal oxide layer comprises at least one of RuO₂ or IrO₂.

4. The semiconductor device according to any one of claims 1 to 3, wherein
a thickness of the composite layer is less than or equal to 20 Å.

5. The semiconductor device according to any one of claims 1 to 4, wherein
the dielectric layer comprises SiO₂; and
the high-dielectric-constant oxide layer comprises at least one of HfO₂ or ZrO₂.

6. The semiconductor device according to any one of claims 1 to 5, wherein
the high-dielectric-constant metal gate further comprises a work function layer, a glue layer, and a metal gate layer that are sequentially disposed on a surface of the composite layer in a stacked manner.

7. The semiconductor device according to claim 6, wherein
the work function layer comprises an N-type work function layer and a P-type work function layer.

8. The semiconductor device according to any one of claims 1 to 7, wherein
the transistor is a fin field effect transistor; or
the transistor is a gate all around field effect transistor.

9. A semiconductor device manufacturing method, comprising:
sequentially forming a dielectric layer and a high-dielectric-constant oxide layer on a substrate; and
sequentially forming a first metal oxide layer, a first metal layer, and a second metal oxide layer on a surface of the high-dielectric-constant oxide layer, wherein the first metal oxide layer and the second metal oxide layer each comprise a conductive metal oxide, and metal elements comprised in the first metal oxide layer, the first metal layer, and the second metal oxide layer are the same.

10. The semiconductor device manufacturing method according to claim 9, wherein
the sequentially forming a first metal oxide layer, a first metal layer, and a second metal oxide layer on a surface of the high-dielectric-constant oxide layer comprises:
sequentially depositing the first metal oxide layer, the first metal layer, and the second metal oxide layer on the surface of the high-dielectric-constant oxide layer through in-situ atomic layer deposition.

11. An electronic device, comprising a printed circuit board and the semiconductor device according to any one of claims 1 to 8, wherein the semiconductor device is electrically connected to the printed circuit board.
